# DEMANDE DE BREVET EUROPEEN

(11) **EP 0 859 456 A1**
(43) Date de publication de la demande: **19.08.1998**
(21) Numéro de dépôt: 98200316.2
(22) Date de dépôt: 03.02.1998
(51) Int. Cl.: H02P 7/62, H02P 7/67, H01L 27/02

(54) **Circuit de contrôle d'un moteur électrique.**

(30) Priorité: 14.02.1997 FR 9701748
(71) Demandeur: Philips Electronics N.V., 5621 BA Eindhoven (NL)
(72) Inventeur: Audic, Jean-Philippe, 75008 Paris (FR); Bouvier, Stéphane, 75008 Paris (FR)
(74) Mandataire: Caron, Jean

(57) **Abrégé**

La présente invention concerne un circuit de contrôle destiné à l'alimentation d'un moteur électrique, circuit comportant un transistor de puissance NM de type NMOS et un transistor de puissance PM de type PMOS disposés entre deux bornes d'alimentation VCC et GND, leur noeud intermédiaire formant une sortie reliée à un enroulement Ei du moteur.

Selon l'invention, le caisson B du transistor PM est relié à la borne d'alimentation VCC via une diode d'isolation ID, dont l'anode est connectée à la borne d'alimentation VCC et dont la cathode est connectée au caisson B.

La diode d'isolation ID permet d'éviter que l'enroulement Ei ne soit court-circuité par la diode parasite drain-caisson D du transistor PM en cas de brusque coupure d'alimentation.

Applications : commande de moteurs pour disques de stockage d'informations.

## Description

La présente invention concerne un circuit de contrôle destiné à commander la conduction d'un courant au travers d'un enroulement d'un moteur électrique destiné à produire un champ magnétique mettant le moteur en action, le dit enroulement étant relié à une borne de sortie du circuit, qui est disposé entre une borne positive et une borne négative d'alimentation, et qui comporte :
. un transistor de puissance de type NMOS disposé entre la borne négative d'alimentation et la borne de sortie, et
. un transistor de puissance de type PMOS disposé entre la borne de sortie et la borne positive d'alimentation, le dit transistor étant implanté au sein d'un caisson de diffusion N qui est électriquement relié à la borne positive d'alimentation,
la conduction des transistors de puissance de type PMOS et NMOS étant commandée par des signaux complémentaires.

De tels circuits de contrôle sont couramment utilisés pour commander des dispositifs mettant en oeuvre des disques de stockage d'informations, notamment des disques durs pour équipements informatiques. Ces dispositifs comprennent le plus souvent un premier moteur servant à imprimer au disque un mouvement de rotation et un deuxième moteur servant à la mise en mouvement d'un bras portant une ou plusieurs têtes de lecture/écriture d'informations à la surface du disque. Chaque moteur est muni de bornes d'entrée, dites bornes d'alimentation, qui sont reliées à des enroulements destinés à produire un champ magnétique permettant la mise en action du moteur. Chacune des bornes d'alimentation est reliée à la borne de sortie d'un circuit de contrôle. Lorsque survient une brusque coupure d'alimentation, c'est-à-dire lorsque la tension de la borne positive d'alimentation devient nulle alors que le dispositif est en fonctionnement, le rotor du premier moteur, entraîné par son énergie cinétique, continue à tourner et produit une force électro-motrice aux bornes d'alimentation du dit moteur, qui fonctionne alors en génératrice. Cette force électro-motrice, substituée à la tension d'alimentation du deuxième moteur, doit permettre à celui-ci de déplacer le bras vers une zone du disque, appelée zone de repos, qui est aménagée pour que le bras puisse s'y poser sans provoquer de dommages aux têtes de lecture/écriture.

On constate cependant que la jonction P-N existant entre le drain d'un transistor de puissance PMOS et le caisson dans lequel le dit transistor est implanté donne naissance à une diode parasite. Lorsque la tension de la borne positive d'alimentation est nulle, le caisson étant classiquement relié à la source qui est elle-même reliée à la dite borne positive d'alimentation, cette diode parasite court-circuite la borne du moteur à laquelle elle est reliée par l'intermédiaire de la borne de sortie du circuit de contrôle, en permettant à un important courant de fuite de circuler directement vers une borne de potentiel nul. Ceci empêche l'utilisation de la force électro-motrice produite par le premier moteur pour l'alimentation du deuxième moteur. Diverses solutions ont été proposées pour résoudre ce problème, consistant essentiellement à insérer un composant de puissance permettant de stopper de manière unidirectionnelle le courant de fuite entre la source du transistor PMOS et la borne positive d'alimentation. Ainsi, la solution décrite dans la publication ISBN 3-540-60332-8 "Smart Power ICs" de la société SGS-Thomson présente une diode de puissance dont la cathode est reliée à la source du transistor PMOS et dont l'anode est reliée à la borne positive d'alimentation. Cette solution présente deux inconvénients majeurs : un tel composant de puissance est coûteux, et il engendre à ses bornes une chute de tension non négligeable. En effet, en régime de fonctionnement normal, la valeur de la tension d'alimentation est, à l'heure actuelle de l'ordre de 5 Volts, et des efforts de développement considérables sont continuellement déployés pour réduire cette valeur, dans un double but général d'économie d'énergie et de réduction de l'encombrement des circuits électroniques. La diode de puissance produisant à ses bornes une chute de tension de l'ordre de 0,5 Volts, dans le cas le plus avantageux où la diode est du type Schottky, elle réduit d'au moins 10% l'énergie utile fournie au moteur et donc le rendement énergétique du dispositif, cette influence néfaste de la diode de puissance sur le rendement étant appelée à croître à mesure que la valeur de la tension d'alimentation diminuera.

La présente invention a pour but de remédier simultanément à ces deux inconvénients, en proposant une solution faisant appel à un composant peu coûteux et disposé de telle sorte qu'il n'intervienne pas, en régime de fonctionnement normal, dans l'acheminement de l'énergie depuis la borne positive d'alimentation vers le moteur commandé par le circuit de contrôle.

En effet, selon la présente invention, un circuit de contrôle tel que décrit dans le paragraphe introductif est caractérisé en ce que le caisson du transistor de puissance de type PMOS est relié à la borne positive d'alimentation via une diode, dite d'isolation, dont l'anode est connectée à la borne positive d'alimentation et dont la cathode est connectée au caisson.

Dans ce circuit de contrôle, l'énergie est acheminée directement au travers de la source du transistor de puissance PMOS vers la borne de sortie en régime de fonctionnement normal. La diode d'isolation n'intervient que lorsque la tension de la borne positive d'alimentation est inférieure d'une tension de seuil, qui est typiquement de l'ordre de 0,7 Volts, à la tension de la borne de sortie. La diode parasite née de la jonction drain-caisson est alors potentiellement passante et capable de conduire un courant de fuite, mais celui-ci est bloqué par la diode d'isolation qui est polarisée en inverse. Toute possibilité de court-circuit étant ainsi supprimée, la force électro-motrice produite par le moteur est alors utilisable en tant que tension d'alimentation de substitution, jusqu'à épuisement de l'énergie cinétique du rotor du moteur.

Ainsi qu'exposé précédemment, plusieurs circuits de contrôle doivent être mis en oeuvre pour commander un moteur présentant une pluralité de bornes d'alimentation. L'invention concerne donc également un circuit de commande d'un moteur électrique qui comporte au moins deux bornes reliées à au moins un enroulement destiné à produire, lorsqu'il est parcouru par un courant, un champ magnétique mettant le moteur en action, circuit comprenant un étage de contrôle présentant au moins deux bornes de sortie, chacune reliée à l'une des bornes du moteur, une borne positive et une borne négative d'alimentation, et comportant au moins deux branches, chacune composée d'un transistor de puissance de type NMOS disposé entre la borne négative d'alimentation et l'une des bornes de sortie, et d'un transistor de puissance de type PMOS disposé entre la dite borne de sortie et la borne positive d'alimentation, ce transistor étant implanté au sein d'un caisson de diffusion N qui est électriquement relié à la borne positive d'alimentation, la conduction des transistors de puissance de types PMOS et NMOS d'une même branche étant commandée par des signaux complémentaires, caractérisé en ce que chacun des caissons des transistors de puissance de type PMOS est relié à la borne positive d'alimentation via une diode dite d'isolation, dont l'anode est connectée à la dite borne positive et dont la cathode est connectée au dit caisson.

Dans une variante d'un tel circuit de commande, les caissons des transistors de puissance de type PMOS sont tous reliés à la borne positive d'alimentation via une même diode d'isolation.

Cette variante est économiquement intéressante, car elle ne nécessite l'emploi que d'une seule diode d'isolation pour l'ensemble du circuit de commande.

Ainsi qu'annoncé plus haut, la structure du circuit de commande selon l'invention le rend particulièrement bien adapté à la commande de moteurs au sein de dispositifs mettant en oeuvre des disques de stockage d'informations. Dans un mode de réalisation particulièrement avantageux, l'invention concerne donc également un circuit de pilotage d'un disque de stockage d'informations, destiné à contrôler un premier et un deuxième moteurs, chacun comportant au moins deux bornes reliées à au moins un enroulement destiné à produire, lorsqu'il est parcouru par un courant, un champ magnétique mettant le moteur en action, le premier moteur étant destiné à imprimer au disque un mouvement de rotation, le deuxième moteur étant destiné à la mise en mouvement d'un bras portant au moins une tête de lecture/écriture d'informations à la surface du disque, caractérisé en ce qu'il comprend un premier et un deuxième circuits de commande tels que décrits plus haut, chacune des bornes de sortie des premier et deuxième circuits de commande étant respectivement reliée à l'une des bornes des premier et deuxième moteurs, les caissons des transistors de puissance de type PMOS contenus dans les circuits de commande étant tous reliés à la borne positive d'alimentation via une même diode d'isolation, l'une des bornes de sortie du deuxième circuit de commande étant reliée à la cathode de la diode d'isolation via un transistor de puissance de type PMOS, dit de parcage, qui est destiné, en cas de brusque coupure d'alimentation, à devenir conducteur entre un premier instant où la tension de la borne positive d'alimentation devient nulle et un deuxième instant où la tension aux bornes du premier moteur devient nulle.

En régime de fonctionnement normal, la tension de la borne positive d'alimentation est acheminée depuis la dite borne vers les moteurs au travers des transistors de puissance de type PMOS. En cas de brusque coupure d'alimentation, le transistor de parcage devient conducteur et permet d'acheminer vers le deuxième moteur l'énergie nécessaire au déplacement du bras portant les têtes de lecture/écriture vers une zone de repos, énergie provenant de la force électro-motrice produite aux bornes d'alimentation du premier moteur qui fonctionne alors en génératrice. La diode d'isolation prévient toute fuite d'énergie vers la borne positive d'alimentation au travers des diodes parasites constituées par les jonctions drain-caisson des transistors PMOS.

Dans une variante de ce circuit de pilotage, le caisson du transistor de parcage est relié au drain du dit transistor.

Cette configuration tire parti de la présence d'une diode parasite constituée ici par la jonction source-caisson du transistor de parcage. En effet, si le caisson est relié au drain, c'est entre la source et le caisson qu'apparaît la jonction P-N qui constitue la dite diode parasite. Lorsque l'énergie cinétique du rotor du premier moteur s'épuise, la valeur de la force électro-motrice produite par le dit moteur diminue, jusqu'à un seuil en-dessous duquel elle n'est plus suffisante pour maintenir la conduction du transistor de parcage. La diode parasite, qui est alors passante, permet alors au reliquat d'énergie fourni par le premier moteur de parvenir au deuxième moteur sous la forme d'un courant qui la traverse.

L'invention sera mieux comprise à l'aide de la description suivante de quelques modes de réalisation, faite à titre d'exemple non-limitatif et en regard des dessins annexés, dans lesquels :
- la figure 1 est un schéma décrivant l'architecture de base d'un circuit de contrôle connu,
- la figure 2 est un schéma décrivant un circuit de contrôle selon l'invention,
- la figure 3 est un schéma décrivant un circuit de commande de moteur pour la mise en rotation d'un disque de stockage d'informations, et
- la figure 4 est un schéma décrivant un circuit de commande de moteur pour la mise en mouvement d'un bras portant une ou plusieurs têtes de lecture/écriture à la surface d'un disque de stockage d'informations.

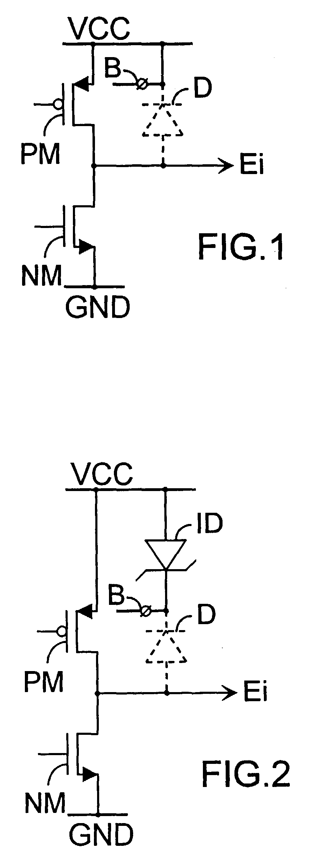

La figure 1 représente schématiquement l'architecture de base d'un circuit de contrôle connu, qui est disposé entre une borne positive VCC et une borne négative GND d'alimentation. Ce circuit est destiné à commander la conduction d'un courant au travers d'un enroulement Ei d'un moteur électrique destiné à produire un champ magnétique mettant le moteur en action. Le moteur, bien connu de l'homme du métier, n'est pas représenté sur la figure. L'enroulement Ei est relié à une borne de sortie du circuit, lequel comporte :
. un transistor de puissance NM de type NMOS disposé entre la borne négative d'alimentation GND et la borne de sortie, et
. un transistor de puissance PM de type PMOS disposé entre la borne de sortie et la borne positive d'alimentation VCC, le dit transistor PM étant implanté au sein d'un caisson de diffusion N qui est électriquement relié à la borne positive d'alimentation VCC.
La conduction des transistors de puissance de types PMOS et NMOS est commandée par des signaux complémentaires, les transistors PM et NM étant respectivement conducteur et bloqué ou bloqué et conducteur selon la nature du champ magnétique que l'enroulement Ei doit produire. La diode D représentée en traits pointillés est une diode parasite née de la construction même du transistor PM. En effet, la source de ce transistor est nécessairement reliée au point de potentiel le plus élevé du circuit, c'est-à-dire à la borne positive d'alimentation VCC. Le caisson B, représenté sous la forme d'un trait gras associé à une borne de connexion, doit être polarisé à l'aide d'une tension positive, ce qui est obtenu en le reliant à la source du transistor PM. La jonction drain-caisson formant une jonction P-N, une diode parasite D apparaît, dont la cathode est reliée à la borne positive d'alimentation et l'anode au drain du transistor PM, ainsi que représenté sur la figure 1. Si l'influence de cette diode parasite D ne se fait pas sentir en régime de fonctionnement normal, où l'énergie est acheminée depuis la borne positive d'alimentation VCC vers l'enroulement Ei via le trajet source-drain du transistor de puissance PM, elle peut devenir très néfaste en cas de brusque coupure d'alimentation. Le rotor du moteur, entraîné par son énergie cinétique, continue à tourner et produit aux bornes de l'enroulement Ei une force électro-motrice qui doit être utilisée comme tension d'alimentation de substitution pendant le temps nécessaire pour placer l'ensemble du dispositif dont font partie le circuit de contrôle et le moteur dans une position de repos. Or il apparaît clairement que, la tension de la borne positive d'alimentation étant à présent nulle, l'enroulement Ei est court-circuité par la diode D et que, par conséquent, la force électro-motrice générée par le moteur aux bornes de l'enroulement Ei est inutilisable.

La figure 2 représente schématiquement un circuit de contrôle conforme à l'invention. Ce circuit de contrôle reprend l'architecture de base décrite ci-dessus, les éléments communs aux figures 1 et 2 étant dotés des mêmes références dans le but de faciliter la compréhension de l'exposé. Dans ce circuit de contrôle, le caisson B du transistor de puissance PM n'est plus relié à la source du dit transistor PM mais directement à la borne positive d'alimentation VCC via une diode ID, dite d'isolation, dont l'anode est connectée à la borne positive d'alimentation VCC et dont la cathode est connectée au caisson B. Dans ce circuit de contrôle, l'énergie est acheminée directement au travers du trajet source-drain du transistor de puissance PM vers l'enroulement Ei en régime de fonctionnement normal. La diode d'isolation ID n'intervient que lorsque la tension de la borne positive d'alimentation VCC est inférieure d'une tension de seuil de la diode D, qui est typiquement de l'ordre de 0,7 Volts, à la tension de la borne de sortie. La diode parasite D est alors potentiellement passante et capable de conduire un courant de fuite, mais celui-ci est bloqué par la diode d'isolation ID qui est polarisée en inverse. Toute possibilité de court-circuit est ainsi supprimée, et la force électro-motrice produite par le moteur aux bornes de l'enroulement Ei est alors utilisable en tant que tension d'alimentation de substitution, jusqu'à épuisement de l'énergie cinétique du rotor du moteur.

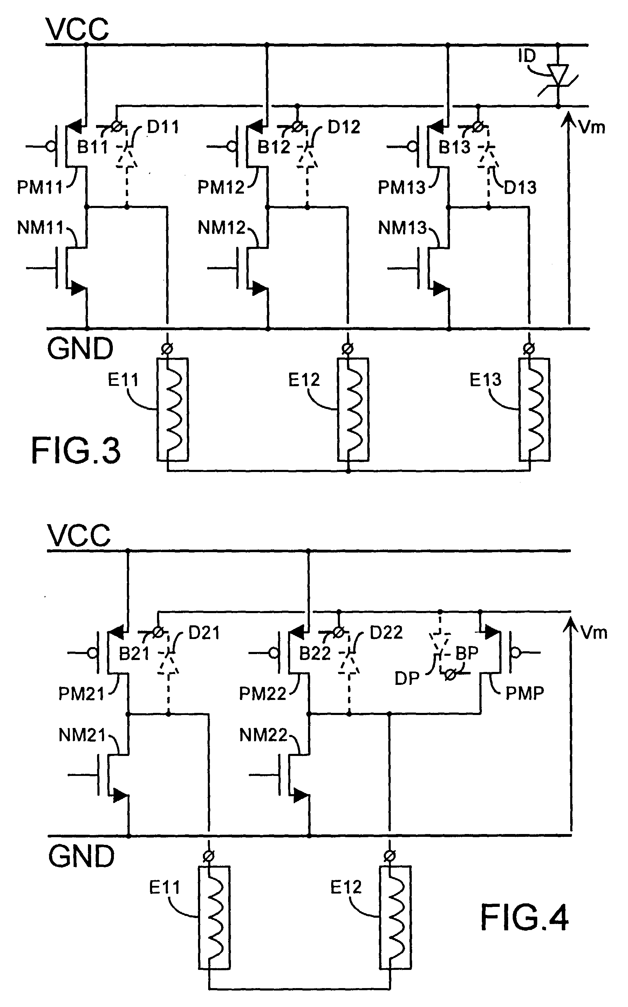

La figure 3 représente schématiquement un premier circuit de commande d'un premier moteur pour la mise en rotation d'un disque de stockage d'informations. Dans cet exemple, le premier moteur, dont seuls les enroulements E11, E12 et E13 sont représentés, est un moteur triphasé et présente trois bornes d'alimentation, chacune reliée à l'un des dits enroulements. Le premier circuit de commande comprend donc un étage de contrôle présentant trois bornes de sortie, chacune reliée à l'une des bornes du premier moteur, une borne positive et une borne négative d'alimentation, respectivement VCC et GND. L'étage de contrôle comporte trois branches, chacune composée d'un transistor de puissance de type NMOS, NM11, NM12, NM13, disposé entre la borne négative d'alimentation GND et l'une des bornes de sortie, et d'un transistor de puissance de type PMOS, PM11, PM12, PM13, disposé entre la dite borne de sortie et la borne positive d'alimentation VCC. Ces transistors PMOS PM11, PM12 et PM13 sont implantés au sein de caissons B11, B12 et B13 de diffusion N qui sont électriquement reliés à la borne positive d'alimentation VCC via une même diode d'isolation ID, dont l'anode est connectée à la dite borne positive VCC et dont la cathode est connectée aux dits caissons. Cette diode d'isolation ID empêche le passage de courants de fuite depuis les bornes d'alimentation du premier moteur vers la borne positive d'alimentation VCC via les diodes parasites D11, D12 et D13 créées par les jonctions drain-caisson des transistors PMOS PM11, PM12 et PM13. Si la topographie du circuit le permet, les transistors PMOS PM11, PM12 et PM13 pourront avantageusement être implantés au sein d'un même caisson. La conduction des transistors de puissance de types PMOS et NMOS d'une même branche est commandée par des signaux complémentaires, de sorte que deux des enroulements E11, E12 ou E13 ne soient alimentés à un instant donné, selon un ordre bien connu du spécialiste. En cas de brusque coupure d'alimentation, c'est-à-dire lorsque le potentiel de la borne positive d'alimentation VCC devient nul, le rotor du premier moteur, entraîné par son énergie cinétique, continue à tourner et permet donc au premier moteur de produire à ses bornes d'alimentation une force électro-motrice, fonctionnant ainsi en génératrice jusqu'à l'arrêt du rotor. L'énergie ainsi développée est matérialisée par une tension Vm présente entre la cathode de la diode d'isolation et la borne négative d'alimentation GND, laquelle tension Vm peut être utilisée en tant que tension d'alimentation de substitution.

La figure 4 représente schématiquement un deuxième circuit de commande d'un deuxième moteur pour la mise en mouvement d'un bras portant une ou plusieurs têtes de lecture/écriture à la surface d'un disque de stockage d'informations. Le deuxième circuit de commande sera avantageusement joint au premier au sein d'un même circuit intégré, lequel pourra alors assurer le pilotage de l'ensemble du dispositif mettant en oeuvre le disque de stockage d'informations. Dans cet exemple, le deuxième moteur, dont seuls les deux demi-enroulements E21 et E22 sont représentés, est un moteur biphasé et présente deux bornes d'alimentation, chacune reliée à l'un des dits demi-enroulements E21 et E22. Le deuxième circuit de commande comprend donc un étage de contrôle présentant deux bornes de sortie, chacune reliée à l'une des bornes du deuxième moteur, une borne positive et une borne négative d'alimentation, respectivement VCC et GND, qui sont reliées aux bornes d'alimentation du premier circuit de commande. L'étage de contrôle comporte deux branches, chacune composée d'un transistor de puissance de type NMOS, NM21 et NM22, disposé entre la borne négative d'alimentation GND et l'une des bornes de sortie, et d'un transistor de puissance de type PMOS, PM21 et PM22, disposé entre la dite borne de sortie et la borne positive d'alimentation VCC. Ces transistors PMOS PM21 et PM22 sont implantés au sein de caissons B21 et B22 de diffusion N qui sont électriquement reliés à la borne positive d'alimentation VCC via la diode d'isolation ID du premier circuit de commande. La diode d'isolation ID empêche le passage de courants de fuite depuis les bornes d'alimentation du deuxième moteur vers la borne positive d'alimentation via les diodes parasites D21 et D22 créées par les jonctions drain-caisson des transistors PMOS PM21 et PM22. Si la topographie du circuit le permet, les transistors PMOS PM21 et PM22 pourront avantageusement être implantés au sein d'un même caisson, éventuellement le caisson commun aux transistors de puissance de type PMOS du premier circuit de commande. La conduction des transistors de puissance de types PMOS et NMOS d'une même branche est commandée par des signaux complémentaires, de sorte que seuls le transistor de type PMOS d'une branche et le transistor de type NMOS de l'autre branche soient conducteurs à un instant donné, le sens du courant parcourant alors les deux demi-enroulements déterminant le sens de déplacement du bras. L'une des bornes de sortie du deuxième circuit de commande est reliée à la cathode de la diode d'isolation ID via un transistor de puissance PMP de type PMOS, dit de parcage, qui est destiné, en cas de brusque coupure d'alimentation, à devenir conducteur entre un premier instant où la tension de la borne positive d'alimentation VCC devient nulle et un deuxième instant où la tension Vm présente aux bornes du premier moteur devient nulle, substituant ainsi la tension Vm produite par le premier moteur à la tension d'alimentation du deuxième moteur. Cette structure permet d'imposer à la tension Vm une valeur supérieure à une tension de seuil de la diode DP au cours du parcage, ce qui peut s'avérer avatageux dans certaines applications où un fort courant est nécessaire pour commander le retrait du bras vars la zone de repos. Le choix de celle des bornes de sortie du deuxième circuit de commande qui doit être reliée au transistor de parcage se fait en fonction de la configuration du disque de stockage d'informations, et particulièrement en fonction de l'endroit où est aménagée la zone de repos. Si, comme c'est classiquement le cas, celle-ci a été disposée à proximité du centre du disque, où la vitesse tangentielle est la plus faible, on choisira la borne de sortie permettant de commander le retrait du bras vers le centre du disque, qui est dans cet exemple la borne qui est reliée au demi-enroulement E12.

Dans le mode de réalisation représenté sur la figure 4, le caisson BP du transistor de parcage PMP est relié au drain du dit transistor. C'est donc entre la source et le caisson de ce transistor qu'apparaît une jonction P-N qui constitue une diode parasite DP. Lorsque l'énergie cinétique du rotor du premier moteur s'épuise, la valeur de la tension Vm diminue, jusqu'à un seuil dont la valeur est typiquement de l'ordre de 1 Volt et en-dessous duquel elle n'est plus suffisante pour maintenir la conduction du transistor de parcage PMP. La diode parasite DP, qui est alors passante, permet au reliquat d'énergie fourni par le premier moteur de parvenir au deuxième moteur sous la forme d'un courant qui la traverse.

## Revendications

1. Circuit de contrôle destiné à commander la conduction d'un courant au travers d'un enroulement d'un moteur électrique destiné à produire un champ magnétique mettant le moteur en action, le dit enroulement étant relié à une borne de sortie du circuit, qui est disposé entre une borne positive et une borne négative d'alimentation, et qui comporte :
. un transistor de puissance de type NMOS disposé entre la borne négative d'alimentation et la borne de sortie, et
. un transistor de puissance de type PMOS disposé entre la borne de sortie et la borne positive d'alimentation, le dit transistor étant implantê au sein d'un caisson de diffusion N qui est électriquement relié à la borne positive d'alimentation,
la conduction des transistors de puissance de types PMOS et NMOS étant commandée par des signaux complémentaires,
caractérisé en ce que le caisson du transistor de puissance de type PMOS est relié à la borne positive d'alimentation via une diode, dite d'isolation, dont l'anode est connectée à la borne positive d'alimentation et dont la cathode est connectée au caisson.

2. Circuit de commande d'un moteur électrique qui comporte au moins deux bornes reliées à au moins un enroulement destiné à produire, lorsqu'il est parcouru par un courant, un champ magnétique mettant le moteur en action, circuit comprenant un étage de contrôle présentant au moins deux bornes de sortie, chacune reliée à l'une des bornes du moteur, une borne positive et une borne négative d'alimentation, et comportant au moins deux branches, chacune composée d'un transistor de puissance de type NMOS disposé entre la borne négative d'alimentation et l'une des bornes de sortie, et d'un transistor de puissance de type PMOS disposé entre la dite borne de sortie et la borne positive d'alimentation, ce transistor étant implanté au sein d'un caisson de diffusion N qui est électriquement relié à la borne positive d'alimentation, la conduction des transistors de puissance de type PMOS et NMOS d'une même branche étant commandée par des signaux complémentaires,
caractérisé en ce que chacun des caissons des transistors de puissance de type PMOS est relié à la borne positive d'alimentation via une diode dite d'isolation, dont l'anode est connectée à la dite borne positive et dont la cathode est connectée au dit caisson.

3. Circuit de commande selon la revendication 2, caractérisé en ce que les caissons des transistors de puissance de type PMOS sont tous reliés à la borne positive d'alimentation via une même diode d'isolation.

4. Circuit de pilotage d'un disque de stockage d'informations, destiné à contrôler un premier et un deuxième moteurs, chacun comportant au moins deux bornes reliées à au moins un enroulement destiné à produire, lorsqu'il est parcouru par un courant, un champ magnétique mettant le moteur en action, le premier moteur étant destiné à imprimer au disque un mouvement de rotation, le deuxième moteur étant destiné à la mise en mouvement d'un bras portant au moins une tête de lecture/écriture d'informations à la surface du disque, caractérisé en ce qu'il comprend un premier et un deuxième circuits de commande conformes à la revendication 2, chacune des bornes de sortie des premier et deuxième circuits de commande étant respectivement reliée à l'une des bornes des premier et deuxième moteurs, les caissons des transistors de puissance de type PMOS contenus dans les circuits de commande étant tous reliés à la borne positive d'alimentation via une même diode d'isolation, l'une des bornes de sortie du deuxième circuit de commande étant reliée à la cathode de la diode d'isolation via un transistor de puissance de type PMOS, dit de parcage, qui est destiné, en cas de brusque coupure d'alimentation, à devenir conducteur entre un premier instant où la tension de la borne positive d'alimentation devient nulle et un deuxième instant où la tension aux bornes du premier moteur devient nulle.

5. Circuit de pilotage d'un disque de stockage d'informations selon la revendication 4, caractérisé en ce que le caisson du transistor de parcage est relié au drain du dit transistor.
